# EUROPÄISCHE PATENTANMELDUNG

(11) **EP 4 632 418 A1**
(43) Veröffentlichungstag der Anmeldung: **15.10.2025**
(21) Anmeldenummer: 24168911.6
(22) Anmeldetag: 08.04.2024
(51) Int. Cl.: G01R 33/28, G01R 33/48

(54) **LOKALISIERUNG EINES ABZUBILDENDEN OBJEKTS IN EINER UNTERSUCHUNGSRÖHRE EINES MAGNETRESONANZTOMOGRAPHIESYSTEMS**

(71) Anmelder: Siemens Healthineers AG, 91301 Forchheim (DE)
(72) Erfinder: Grodzki, David, 91058 Erlangen (DE)
(74) Vertreter: Siemens Healthineers Patent Attorneys

(57) **Zusammenfassung**

Zur Lokalisierung eines abzubildenden Objekts (6) in einer Untersuchungsröhre (5) eines MRT-Systems (1) werden Projektionsmessdaten (23) einer MR-Projektionsmessung in wenigstens einer Richtung senkrecht zu einer Längsrichtung der Untersuchungsröhre (5) erhalten und abhängig von den Projektionsmessdaten (23) wird wenigstens ein Abstand des Objekts (6) zu einer Innenwand (20) der Untersuchungsröhre (5) bestimmt.

## Beschreibung

Die vorliegende Erfindung betrifft ein Verfahren zur Lokalisierung eines abzubildenden Objekts in einer Untersuchungsröhre eines Magnetresonanztomographie-Systems (MRT-Systems) sowie ein darauf aufbauendes Verfahren zum Betreiben eines MRT-Systems. Die Erfindung betrifft ferner ein Datenverarbeitungssystem zur Durchführung solcher Verfahren, ein MRT-System mit einem solchen Datenverarbeitungssystem, sowie ein entsprechendes Computerprogrammprodukt.

Bei der Magnetresonanz-Bildgebung (MR-Bildgebung) werden die Spins des abzubildenden Objekts mit resonanten Hochfrequenzfeldern (HF-Feldern) aus ihrer Ruhelage ausgelenkt. Diese HF-Felder führen zu einer Erwärmung des Objekts, insbesondere von Gewebe, was durch die spezifische Absorbtionsrate (SAR) beschrieben wird. Vor allem in der unmittelbaren Nähe zu einer Sendespule, insbesondere einer in dem Scannergehäuse des MRT-Scanners außerhalb der Untersuchungsröhre (englisch: "bore") für das abzubildende Objekt verbauten Sendespule, kann es lokal zu hohen Intensitäten und entsprechender Erhitzung kommen.

Um dies zu vermeiden, wird beispielsweise ein geschätzter Abstand des Objekts von der Innenwand der Untersuchungsröhre angenommen und entsprechend diesem geschätzten Abstand wird die Sendeleistung der entsprechenden Sendespule begrenzt. Da der tatsächliche Abstand nicht bekannt ist oder verifiziert wird, werden hierbei vergleichsweise konservative Abschätzungen zugrunde gelegt, sprich der geschätzte Abstand ist in der Regel geringer als der minimale tatsächliche Abstand des Objekts von der Innenwand. Dies hat zur Folge, dass die Sendeleistung möglicherweise stärker eingeschränkt wird als notwendig. Dies wiederum führt zu einer verringerten Bildqualität.

Prinzipiell wäre es denkbar, die Position des Objekts in der Untersuchungsröhre durch ein Kamerasystem und/oder sonstige externe Sensoren zu bestimmen, statt den geschätzten Abstand zugrunde zu legen. Dies führt jedoch zu erhöhtem Hardwareaufwand.

In der Veröffentlichung D. Grodzki et. al.: "Ultrashort Echo Time Imaging Using Pointwise Encoding Time Reduction With Radial Acquisition (PETRA)" wird die PETRA Sequenz beschrieben, bei der der äußere k-Raum mit radialen Halbprojektionen gefüllt wird, während das k-Raum-Zentrum punktweise kartesisch abgetastet wird. Diese Hybridsequenz kombiniert die Eigenschaften der Einzelpunktaufnahme mit der Radialprojektion.

Die Veröffentlichung M. Robson et al.: "Magnetic resonance: an introduction to ultrashort TE (UTE) imaging.", J. Comput. Assist. Tomogr. 27 (6), 825-46 gibt unter anderem einen Überblick über die klinische Verwendung von UTE-Impulssequenzen für die Bildgebung von Gewebe oder Gewebekomponenten.

In der Veröffentlichung A. Yildiz et al.: "Zero Echo Time Musculoskeletal MRI: Technique, Optimization, Applications, and Pitfalls.", Radiographics 42 (5), 1398-1414 wird die ZTE-Bildgebung beschrieben, eine MRT-Technik, die Bilder erzeugt, die denen von Röntgenaufnahmen oder CT ähneln. ZTE wird insbesondere eingesetzt, um Gewebe wie Knochen mit sehr kurzen T2-Werten gut sichtbar zu machen.

Es ist eine Aufgabe der vorliegenden Erfindung, eine Möglichkeit zur Lokalisierung eines abzubildenden Objekts in einer Untersuchungsröhre MRT-Systems anzugeben, ohne hierfür zusätzliche Sensoren zu benötigen.

Diese Aufgabe wird durch den Gegenstand des unabhängigen Anspruchs gelöst. Vorteilhafte Weiterbildungen und bevorzugte Ausführungsformen sind Gegenstand der abhängigen Ansprüche.

Die Erfindung basiert auf der Idee, einen Abstand des Objekts zu der Innenwand der Untersuchungsröhre abhängig von Projektionsmessdaten einer Magnetresonanz-Projektionsmessung (MR-Projektionsmessung) in wenigstens einer Richtung senkrecht zu einer Längsrichtung der Untersuchungsröhre zu ermitteln.

Gemäß einem Aspekt der Erfindung wird ein Verfahren zur Lokalisierung eines abzubildenden Objekts in einer Untersuchungsröhre des MRT-Systems angegeben. Projektionsmessdaten einer MR-Projektionsmessung in wenigstens einer Richtung senkrecht zu einer Längsrichtung der Untersuchungsröhre werden erhalten oder mittels des MRT-Systems erzeugt. Abhängig von den Projektionsmessdaten wird wenigstens ein Abstand des Objekts zu einer Innenwand der Untersuchungsröhre bestimmt.

Das erfindungsgemäße Verfahren kann in verschiedenen Ausführungsformen rein computerimplementiert sein. Sofern nicht anders angegeben, können alle Schritte des computerimplementierten Verfahrens von einem Datenverarbeitungssystem durchgeführt werden, das wenigstens ein Datenverarbeitungsgerät beinhaltet. Insbesondere ist das wenigstens eine Datenverarbeitungsgerät dazu eingerichtet oder angepasst, die Schritte des computerimplementierten Verfahrens auszuführen. Zu diesem Zweck kann das wenigstens eine Datenverarbeitungsgerät beispielsweise ein Computerprogramm speichern, das Befehle beinhaltet, die, wenn sie von dem wenigstens einen Datenverarbeitungsgerät ausgeführt werden, das wenigstens eine Datenverarbeitungsgerät veranlassen, das computerimplementierte Verfahren auszuführen. Das computerimplementierte Verfahren kann auch ganz oder teilweise in Hardware implementiert sein. Die Ausdrücke "Datenverarbeitungssystem" und "wenigstens ein Datenverarbeitungsgerät" können hier und im Folgenden austauschbar verwendet werden. Dies gilt auch für entsprechende davon abgeleitete Ausdrücke.

Für den Fall, dass das wenigstens eine Datenverarbeitungsgerät zwei oder mehr Datenverarbeitungsgeräte beinhaltet, können bestimmte von dem wenigstens einen Datenverarbeitungsgerät durchgeführte Schritte auch so verstanden werden, dass verschiedene Datenverarbeitungsgeräte verschiedene Schritte oder verschiedene Teile eines Schrittes durchführen. Insbesondere ist es nicht erforderlich, dass jedes Datenverarbeitungsgerät die Schritte durchführt. Mit anderen Worten kann die Durchführung der Schritte auf die zwei oder mehr Datenverarbeitungsgeräte verteilt werden.

Aus jeder Ausführungsform des computerimplementierten Verfahrens ergibt sich eine entsprechende Ausführungsform eines Verfahrens zur Lokalisierung eines abzubildenden Objekts, das nicht rein computerimplementiert ist, indem entsprechende Schritte zur Erzeugung der Projektionsmessdaten einbezogen werden, also insbesondere die MR-Projektionsmessung als Bestandteil des Verfahrens durchgeführt wird. Die MR-Projektionsmessung wird in solchen Ausführungsformen mittels eins MRT-Systems durchgeführt, welches beispielsweise auch das Datenverarbeitungssystem beinhalten kann.

Eine MR-Projektionsmessung kann als MR-Messung verstanden werden, die keine dreidimensionale Ortskodierung nutzt, sondern nur eine eindimensionale oder zweidimensionale Ortskodierung. Vorliegend wird also bei der MR-Projektionsmessung keine Ortskodierung in der Längsrichtung, im Folgenden als Z-Richtung bezeichnet, genutzt, sondern nur eine eindimensionale Ortskodierung in einer zur Z-Richtung senkrechten Ebene, die durch eine X-Richtung, beispielsweise eine horizontale Richtung, und eine Y-Richtung, beispielsweise eine vertikale Richtung, definiert ist, oder eine zweidimensionale Ortskodierung in der X-Y-Ebene. Die Z-Richtung kann dabei insbesondere einer Richtung des Hauptmagnetfelds, auch als B0 bezeichnet, des MRT-Systems entsprechen. Zweidimensionale MR-Projektionsmessungen entsprechen also gewissermaßen einem Durchleuchtungsbild mit unendlich großer Schichtdicke. MR-Projektionsmessungen haben für das erfindungsgemäße Verfahren den Vorteil, dass sich diese innerhalb sehr kurzer Zeit durchführen lassen und die MR-Signale aus einem sehr großen Volumen stammen, sodass nur sehr geringes Rauschen auftritt.

Mit MR-Projektionsmessungen senkrecht zur Längsrichtung lässt sich also die Ausdehnung des Objekts im Inneren der Untersuchungsröhre bestimmen und damit die entsprechenden Abstände des Objekts von der Innenwand der Untersuchungsröhre. Der wenigstens eine Abstand enthält bei einer eindimensionalen MR-Projektionsmessung entlang einer Richtung w = a*x + b*y, wobei x ein Vektor in X-Richtung und y ein Vektor in Y-Richtung ist, einen Abstand des Objekts von der Innenwand in Richtung von w auf einer Seite der Innenwand und optional einen Abstand des Objekts von der Innenwand in Richtung von w auf der gegenüberliegenden Seite der Innenwand. Bei einer zweidimensionalen MR-Projektionsmessung in der X-Y-Ebene kann der wenigstens eine Abstand einen, zwei oder mehr Abstände des Objekts von der Innenwand in einer oder mehreren Richtungen in der X-Y-Ebene von der Innenwand beinhalten. Das Lokalisieren des Objekts entspricht dem Bestimmen des wenigstens einen Abstands.

Die MR-Projektionsmessung kann beispielsweise als PETRA-Sequenz oder Teil einer PETRA-Sequenz oder als UTE-Sequenz oder Teil einer UTE-Sequenz oder als ZTE-Sequenz oder Teil einer ZTE-Sequenz durchgeführt werden. Es können insbesondere auch andere MRT-Sequenzen mit einer kurzen Echozeit, beispielsweise einer Echozeit von 1 ms oder kürzer, eingesetzt werden.

Die eindimensionale MR-Projektionsmessung kann dabei im gesamten Bereich von einer Seite der Innenwand bis zur gegenüberliegenden durchgeführt werden. Analog kann die zweidimensionale MR-Projektionsmessung an jeder Stelle bis zur Innenwand der Untersuchungsröhre durchgeführt werden. Der wenigstens eine Abstand kann dann zwischen der Innenwand und der Position beziehungsweise den Positionen, an der die Amplitude der aus dem Objekt empfangenen MR-Signale verschwinden oder an der die Amplitude kleiner wird, als ein vorgegebener Schwellwert bestimmt werden. Sollte dies nicht auftreten, ist der entsprechende Abstand gegebenenfalls gleich Null, da eine Berührung der Innenwand durch das Objekt vorliegt.

In manchen Ausführungsformen ist es jedoch auch möglich, dass nicht ganz bis zur Innenwand der Untersuchungsröhre gemessen wird oder gemessen werden kann. Dies kann insbesondere bei MRT-Systemen mit einem Röhrendurchmesser der Untersuchungsröhre von 70 cm oder mehr der Fall sein. Es kann dann auftreten, dass die Amplitude der aus dem Objekt empfangenen MR-Signale im gemessenen Bereich nicht verschwinden oder nicht unter den Schwellwert sinken, obwohl keine Berührung der Innenwand durch das Objekt vorliegt. In diesem Fall können die Projektionsmessdaten in dem Zwischenraum zwischen dem gemessenen Bereich und der Innenwand extrapoliert werden, beispielsweise unter Berücksichtigung typischer zu erwartender Abmessungen des Objekts, insbesondere von Körperteilen wie Armen, Beinen, et cetera. Statt der typischen zu erwartenden Abmessungen können in manchen Ausführungsformen auch die tatsächlichen Abmessungen des Objekts vorab bestimmt werden.

Die Projektionsmessdaten können insbesondere im k-Raum vorliegen und beispielsweise gemäß dem Nyquist Kriterium vollständig abgetastete Daten sein. Zum Bestimmen des wenigstens einen Abstands können dann die Projektionsmessdaten durch Fouriertransformation in den Bildraum transformiert werden. Alternativ können bei nicht vollständig abgetasteten Daten bekannte Rekonstruktionsverfahren verwendet werden, um die Projektionsmessdaten in den Bildraum zu transformieren. Alternativ können die Projektionsmessdaten auch bereits im Bildraum vorliegen.

Durch das erfindungsgemäße Verfahren kann die Lage des Objekts in der Untersuchungsröhre, insbesondere können dessen Abstände zur Innenwand, zuverlässig und automatisch bestimmt werden, ohne dass dafür externe Sensoren eingesetzt werden müssen. Ferner kann die Überwachung der Lage des Objekts auch während einer laufenden MRT-Untersuchung erfolgen. Demzufolge wird es ermöglicht, eine höhere Sendeleistung von Sendespulen, die im Gehäuse des MRT-Scanners außerhalb der Untersuchungsröhre verbaut sind, einzusetzen, ohne zu hohe lokale SAR-Werte zu riskieren.

Beispielsweise kann nach der Bestimmung des wenigstens einen Abstands eine MR-Abbildungsmesssequenz zur Abbildung des abzubildenden Objekts oder ein Teil einer solchen MR-Abbildungsmesssequenz durchgeführt werden, wobei während der MR-Abbildungsmesssequenz oder des Teils der MR-Abbildungsmesssequenz eine Sendeleistung wenigstens einer Sendespule des MRT-Systems, die außerhalb der Untersuchungsröhre in dem MRT-System verbaut ist, auf einen zulässigen Bereich beschränkt wird, der abhängig von dem wenigstens einen Abstand bestimmt wird.

Gemäß zumindest einer Ausführungsform beinhaltet die MR-Projektionsmessung eine PETRA-Sequenz oder einen Teil einer PETRA-Sequenz, insbesondere eine zweidimensionale PETRA-Sequenz oder ein Teil einer zweidimensionalen PETRA-Sequenz.

PETRA-Sequenzen haben den Vorteil, dass mit sehr kleinen Flipwinkeln gearbeitet werden kann, sodass die MR-Projektionsmessung die MR-Abbildungsmesssequenz nicht stört. Zudem sind PETRA-Sequenzen mit ihren ultrakurzen Echozeiten besonders robust gegenüber ungewünschten Effekten in der Nähe der Innenwand der Untersuchungsröhre, wie etwa Gradientennichtlinearitäten, B0-Störungen und so weiter. Signalauslöschungen oder Verzerrungen, wie sie bei längeren Echozeiten oder Spin-Echo-Sequenzen zu befürchten wären, können so zuverlässig vermieden werden.

Gemäß zumindest einer Ausführungsform ist die MR-Projektionsmessung eine eindimensionale erste MR-Projektionsmessung in einer ersten Richtung senkrecht zu der Längsrichtung der Untersuchungsröhre. Die Projektionsmessdaten werden daher als erste Projektionsmessdaten bezeichnet. Wenigstens ein erster Abstand des wenigstens einen Abstands wird abhängig von den ersten Projektionsmessdaten bestimmt.

Wie oben bereits erwähnt, kann die erste Richtung als w1 = a1*x+b1*y ausgedrückt werden. Der wenigstens eine erste Abstand beinhaltet einen ersten Abstand des Objekts von der Innenwand in Richtung von w1 auf einer Seite der Innenwand und optional einen weiteren ersten Abstand des Objekts von der Innenwand in Richtung von w1 auf der gegenüberliegenden Seite der Innenwand. Der zulässige Bereich für die Sendeleistung kann also beispielsweise abhängig von einem Minimalabstand des Objekts von der Innenwand bestimmt werden, der dem kleinsten Abstand des wenigstens einen Abstands entspricht.

Solche Ausführungsformen haben den Vorteil, dass eine eindimensionale MR-Projektionsmessung in extrem kurzer Zeit durchgeführt werden kann, beispielsweise in unter 10 ms, da nur eine einzige Linie oder Speiche im k-Raum abgetastet werden muss.

Die eindimensionale MR-Projektionsmessung kann daher besonders einfach auch in Totzeiten der MR-Abbildungsmesssequenz durchgeführt werden. Insbesondere kann die eindimensionale MR-Projektionsmessung einmalig oder mehrfach mit unterschiedlichen Richtungen wiederholt werden, um mehr Abstände zwischen Objekt und Innenwand zu ermitteln und das Objekt dadurch genauer zu lokalisieren. Es ist insbesondere möglich, dass die verschiedenen eindimensionalen MR-Projektionsmessungen in verschiedenen Totzeiten der MR-Abbildungsmesssequenz durchgeführt werden. Eine Totzeit oder Totzeitphase kann dabei als Zeitraum verstanden werden, innerhalb dessen keine HF-Impulse eingestrahlt werden, keine Gradienten geschaltet sind, und keine MR-Signale erfasst werden. Bei einer Turbo-Spin-Echo, TSE, Sequenz als MR-Abbildungsmesssequenz kann die MR-Projektionsmessung beispielsweise alle paar Sekunden jeweils nach Ablauf einer Repetitionszeit TR durchgeführt werden.

Gemäß zumindest einer Ausführungsform besteht die MR-Projektionsmessung aus wenigstens einer MR-Projektionsmesssequenz, wobei eine maximale Echozeit der MR-Projektionsmesssequenz kleiner oder gleich 2 ms oder kleiner oder gleich 1 ms ist.

Gemäß zumindest einer Ausführungsform werden zweite Projektionsmessdaten einer eindimensionalen zweiten MR-Projektionsmessung in einer von der ersten Richtung verschiedenen zweiten Richtung senkrecht zu der Längsrichtung der Untersuchungsröhre erhalten oder mittels des MRT-Systems erzeugt. Abhängig von den zweiten Projektionsmessdaten wird wenigstens ein zweiter Abstand des wenigstens einen Abstands bestimmt.

In solchen Ausführungsformen wird die eindimensionale MR-Projektionsmessung also wie oben erwähnt zumindest einmalig mit einer anderen Richtung wiederholt. Die zweite Richtung kann als w2 = a2*x+b2*y ausgedrückt werden. Der wenigstens eine zweite Abstand beinhaltet einen zweiten Abstand des Objekts von der Innenwand in Richtung von w2 auf einer Seite der Innenwand und optional einen weiteren zweiten Abstand des Objekts von der Innenwand in Richtung von w2 auf der gegenüberliegenden Seite der Innenwand.

Der wenigstens eine Abstand beinhaltet also insbesondere den wenigstens einen ersten Abstand und den wenigstens einen zweiten Abstand und, in manchen Ausführungsformen, wenigstens einen weiteren Abstand, der durch eine oder mehrere weitere Wiederholungen der eindimensionalen MR-Projektionsmessung mit weiteren Richtungen bestimmt wird. Der zulässige Bereich für die Sendeleistung kann also beispielsweise abhängig von einem Minimalabstand des Objekts von der Innenwand bestimmt werden, der dem kleinsten Abstand des wenigstens einen Abstands entspricht.

Analog kann in Ausführungsformen, in denen die MR-Projektionsmessung eine zweidimensionale MR-Projektionsmessung ist, der Minimalabstand als kleinster Abstand des wenigstens einen Abstands bestimmt werden und beispielsweise der zulässige Bereich für die Sendeleistung basierend auf dem Minimalabstand bestimmt werden.

Gemäß zumindest einer Ausführungsform werden Referenzmessdaten einer MR-Referenzmessung erhalten oder mittels des MRT-Systems erzeugt. Eine Positionsveränderung des Objekts in der Untersuchungsröhre wird abhängig von einem Abgleich der Projektionsmessdaten mit den Referenzmessdaten detektiert.

Insbesondere kann der wenigstens eine Abstand abhängig von einem Ergebnis des Abgleichs bestimmt werden und/oder der zulässige Bereich für die Sendeleistung kann abhängig von dem Ergebnis des Abgleichs bestimmt oder aktualisiert werden.

Die MR-Referenzmessung wird insbesondere vor der MR-Projektionsmessung und beispielsweise vor Beginn der MR-Abbildungsmesssequenz durchgeführt. Die MR-Referenzmessung kann ebenfalls eine eindimensionale oder zweidimensionale MR-Projektionsmessung sein oder auch eine dreidimensionale MR-Messung. Die Projektionsmessdaten können dann mit den Referenzmessdaten abgeglichen werden, wobei die Referenzmessdaten gegebenenfalls von 3D in 2D oder von 3D oder 2D in die entsprechende 1D-Richtung umgerechnet wird. Somit können Änderungen in der Lagerung des Objekts schnell erkannt werden.

Gemäß zumindest einer Ausführungsform wird abhängig von den Projektionsmessdaten wenigstens eine Position in der Ebene senkrecht zu der Längsrichtung der Untersuchungsröhre bestimmt, an der eine MR-Signalintensität gemäß den Projektionsmessdaten kleiner oder gleich einem vorgegebenen Grenzwert ist und der wenigstens eine Abstand wird basierend auf der wenigstens einen Position bestimmt.

Die MR-Projektionsmessung wird hier also insbesondere bis ganz zur Innenwand der Untersuchungsröhre durchgeführt. Die wenigstens eine Position, an der die MR-Signalintensität gemäß den Projektionsmessdaten kleiner oder gleich einem vorgegebenen Grenzwert ist, kann als äußere Grenze des Objekts zu der Innenwand hin interpretiert werden. Der wenigstens eine Abstand lässt sich daher besonders genau bestimmen. Dabei ist ein Durchmesser der Untersuchungsröhre insbesondere kleiner als 70 cm, beispielsweise gleich 60 cm.

Gemäß zumindest einer Ausführungsform wird die MR-Projektionsmessung wenigstens zum Teil während einer Totzeitphase zwischen einem ersten Teil der MR-Abbildungsmesssequenz und einem zweiten Teil der MR-Abbildungsmesssequenz durchgeführt.

Damit kann die MR-Projektionsmessung mit Vorteil während der eigentlichen Untersuchung des Objekts durchgeführt werden. Insbesondere kann somit eine wiederholte Bestimmung beziehungsweise eine Überwachung des wenigstens einen Abstands oder des Minimalabstands realisiert werden.

Gemäß einem weiteren Aspekt der Erfindung wird ein Verfahren zum Betreiben eines MRT-Systems angegeben. Dabei wird ein erfindungsgemäßes Verfahren zur Lokalisierung eines abzubildenden Objekts in einer Untersuchungsröhre des MRT-Systems durchgeführt. Ein zulässiger Bereich für eine Sendeleistung wenigstens einer Sendespule, insbesondere wenigstens einer HF-Sendespule, des MRT-Systems, die außerhalb der Untersuchungsröhre in dem MRT-System verbaut ist, wird abhängig von dem wenigstens einen Abstand bestimmt, insbesondere mittels des Datenverarbeitungssystems. Wenigstens ein Teil einer MR-Abbildungsmesssequenz zur Abbildung des abzubildenden Objekts wird durchgeführt, wobei während der Durchführung der MR-Abbildungsmesssequenz oder des Teils der MR-Abbildungsmesssequenz die Sendeleistung der wenigstens einer Sendespule auf den zulässigen Bereich beschränkt wird, insbesondere mittels eines Steuerungssystems des MRT-Systems.

Die wenigstens eine Sendespule kann beispielsweise in einem Scannergehäuse eines MRT-Scanners des MRT-Systems, welcher die Untersuchungsröhre enthält, verbaut sein. Die wenigstens eine Sendespule kann insbesondere eine sogenannte Körperspule (englisch: "body coil") beinhalten. Hierbei ist zu beachten, dass es sich nicht um eine innerhalb der Untersuchungsröhre befindliche, direkt auf dem Objekt abgebrachte Lokalspule handelt, die mitunter auch als "body coil" bezeichnet wird.

Insbesondere wird die wenigstens eine Sendespule während der MR-Abbildungsmesssequenz oder während des Teils der MR-Abbildungsmesssequenz verwendet, um einen oder mehrere Hochfrequenz-, HF-, Impulse (englisch: radio frequency, RF, pulses) in das Objekt einzustrahlen. Die Sendeleistung entspricht der Strahlungsleistung der HF-Impulse. Somit kann durch die Beschränkung der Sendeleistung auf den zulässigen Bereich eine zu starke Erhitzung des Objekts vermieden werden.

Der zulässige Bereich kann beispielsweise abhängig von wenigstens einem vorgegebenen Maximalwert für den mittleren Betrag der Amplitude eines B1-Feldes während der MR-Abbildungsmesssequenz oder für die mittlere quadratische Amplitude des B1-Feldes während wenigstens eines vorgegebenen Zeitraums bestimmt werden. Jeder Zeitraum des wenigstens einen Zeitraums kann beispielsweise im Bereich [1 s, 10 min] liegen. Jedem Zeitraum des wenigstens einen Zeitraums ist insbesondere einer des wenigstens einen Maximalwerts zugeordnet. Der zulässige Bereich kann beispielsweise einem Bereich [0, Pₘₐₓ] entsprechen, wobei Pₘₐₓ einer maximalen Sendeleistung entspricht. Die maximale Sendeleistung kann also derart bestimmt werden, dass der mittlere Betrag der Amplitude oder der quadratischen Amplitude über jeden Zeitraum des wenigstens einen Zeitraums hinweg kleiner oder gleich dem entsprechend zugeordneten Maximalwert ist.

Beispielsweise kann ein erster Zeitraum des wenigstens einen Zeitraums im Bereich [1 s, 30 s] liegen oder im Bereich [5 s, 15 s] oder kann gleich 10 s sein. Beispielsweise kann ein zweiter Zeitraum des wenigstens einen Zeitraums im Bereich [3 min, 9 min] liegen oder im Bereich [4 min, 8 m] oder kann gleich 6 min sein.

Gemäß zumindest einer Ausführungsform wird die MR-Projektionsmessung wenigstens zum Teil während einer Totzeitphase zwischen einem ersten Teil der MR-Abbildungsmesssequenz und einem zweiten Teil der MR-Abbildungsmesssequenz durchgeführt. Die Sendeleistung der wenigstens einer Sendespule wird während des zweiten Teils der MR-Abbildungsmesssequenz auf den zulässigen Bereich beschränkt.

Gemäß zumindest einer Ausführungsform beinhaltet der wenigstens eine Abstand des Objekts zu der Innenwand zwei oder mehr Abstände des Objekts zu der Innenwand an verschiedenen Positionen in einer Ebene senkrecht zu der Längsrichtung der Untersuchungsröhre. Der zulässige Bereich für die Sendeleistung wird abhängig von einem minimalen Abstand der zwei oder mehr Abstände bestimmt.

Die zwei oder mehr Abstände können dabei aus einer zweidimensionalen MR-Projektionsmessung oder aus einer oder mehreren eindimensionalen Projektionsmessungen bestimmt werden, wie oben erläutert.

Weitere Ausführungsformen des erfindungsgemäßen Verfahrens zum Betreiben eines MRT-Systems folgen unmittelbar aus den verschiedenen Ausgestaltungen des erfindungsgemäßen Verfahrens zur Lokalisierung eines abzubildenden Objekts und umgekehrt. Insbesondere lassen sich einzelne Merkmale und entsprechende Erläuterungen sowie Vorteile bezüglich der verschiedenen Ausführungsformen zu dem erfindungsgemäßen Verfahren zur Lokalisierung eines abzubildenden Objekts analog auf entsprechende Ausführungsformen des erfindungsgemäßen Verfahrens zum Betreiben eines MRT-Systems übertragen und umgekehrt.

Gemäß einem weiteren Aspekt der Erfindung wird ein Datenverarbeitungssystem angegeben, das dazu angepasst ist, ein erfindungsgemäßes Verfahren zur Lokalisierung eines abzubildenden Objekts durchzuführen.

In der vorliegenden Offenbarung können die Ausdrücke "Datenverarbeitungssystem" und "wenigstens ein Datenverarbeitungsgerät" austauschbar verwendet werden. Unter einem Datenverarbeitungsgerät kann insbesondere ein Datenverarbeitungsgerät verstanden werden, das einen Verarbeitungsschaltkreis enthält. Das Datenverarbeitungsgerät kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen ebenso wie ein in Hardware implementierter Datenverarbeitungsprozess.

Das Datenverarbeitungsgerät kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Das Datenverarbeitungsgerät kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Das Datenverarbeitungsgerät kann auch einen physischen oder einen virtuellen Verbund von Computern oder sonstige der genannten Einheiten beinhalten.

In verschiedenen Ausführungsbeispielen beinhaltet das Datenverarbeitungsgerät eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "readonly memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Gemäß einem weiteren Aspekt der Erfindung wird ein MRT-System zur Durchführung einer MR-Abbildungsmesssequenz zur Abbildung eines abzubildenden Objekts angegeben. Das MRT-System weist einen MRT-Scanner mit einer Untersuchungsröhre auf, sowie ein erfindungsgemäßes Datenverarbeitungssystem.

Insbesondere weist das MRT-System alle weiteren Komponenten auf, die erforderlich sind, um eine bekannte MR-Abbildungsmesssequenz durchzuführen, wie etwa eine Hauptmagneteinheit, eine oder mehrere HF-Sendespulen, eine oder mehrere Empfangsspulen, eine oder mehrere Gradientenspulen, ein Steuerungssystem zur Ansteuerung des MRT-Scanners und so weiter.

Gemäß zumindest einer Ausführungsform weist das MRT-System ein Steuerungssystem zur Ansteuerung des MRT-Scanners auf. Der MRT-Scanner weist wenigstens eine Sendespule auf, die außerhalb der Untersuchungsröhre, insbesondere in dem Scannergehäuse des MRT-Scanners, verbaut ist. Das Datenverarbeitungssystem ist dazu angepasst, abhängig von dem wenigstens einen Abstand einen zulässigen Bereich für eine Sendeleistung der wenigstens einen Sendespule zu bestimmen. Das Steuerungssystem ist dazu eingerichtet, den MRT-Scanner zur Durchführung der MR-Abbildungsmesssequenz anzusteuern, sodass die Sendeleistung der wenigstens einer Sendespule auf den zulässigen Bereich beschränkt wird.

Das Steuerungssystem kann insbesondere eines oder mehrere Datenverarbeitungsgeräte gemäß der obigen Definition beinhalten.

Weitere Ausführungsformen des erfindungsgemäßen MRT-System folgen unmittelbar aus den verschiedenen Ausgestaltungen der erfindungsgemäßen Verfahren und umgekehrt. Insbesondere lassen sich einzelne Merkmale und entsprechende Erläuterungen sowie Vorteile bezüglich der verschiedenen Ausführungsformen zu den erfindungsgemäßen Verfahren analog auf entsprechende Ausführungsformen des erfindungsgemäßen MRT-Systems übertragen. Insbesondere ist das erfindungsgemäße MRT-System zum Durchführen eines erfindungsgemäßen Verfahrens zum Betreiben eines MRT-Systems ausgebildet oder programmiert. Insbesondere führt das erfindungsgemäße MRT-System das erfindungsgemäße Verfahren zum Betreiben eines MRT-Systems durch.

Gemäß einem weiteren Aspekt der Erfindung wird ein Computerprogramm mit Befehlen angegeben. Wenn die Befehle durch ein Datenverarbeitungssystem ausgeführt werden, veranlassen die Befehle das Datenverarbeitungssystem dazu, ein erfindungsgemäßes Verfahren zur Lokalisierung eines abzubildenden Objekts durchzuführen.

Die Befehle können beispielsweise als Programmcode vorliegen. Der Programmcode kann beispielsweise als Binärcode oder Assembler und/oder als Quellcode einer Programmiersprache, zum Beispiel C, und/oder als Programmskript, zum Beispiel Python, bereitgestellt sein.

Gemäß einem weiteren Aspekt der Erfindung wird ein weiteres Computerprogramm mit Befehlen angegeben. Wenn die weiteren Befehle durch ein erfindungsgemäßes MRT-System, beispielsweise durch das Datenverarbeitungssystem und/oder das Steuerungssystem des MRT-Systems, ausgeführt werden, veranlassen die Befehle das MRT-System dazu, ein erfindungsgemäßes Verfahren zum Betreiben eines MRT-Systems durchzuführen.

Die weiteren Befehle können beispielsweise als Programmcode vorliegen. Der Programmcode kann beispielsweise als Binärcode oder Assembler und/oder als Quellcode einer Programmiersprache, zum Beispiel C, und/oder als Programmskript, zum Beispiel Python, bereitgestellt sein.

Gemäß einem weiteren Aspekt der Erfindung wird ein computerlesbares Speichermedium angegeben, das ein erfindungsgemäßes Computerprogramm und/oder ein erfindungsgemäßes weiteres Computerprogramm speichert.

Das Computerprogramm, das weitere Computerprogramm und das computerlesbare Speichermedium sind jeweils Computerprogrammprodukte mit den Befehlen beziehungsweise den weiteren Befehlen.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen:
- FIG 1: eine schematische Darstellung einer beispielhaften Ausführungsform eines erfindungsgemäßen MRT-Systems;
- FIG 2: ein schematisches Ablaufdiagramm einer beispielhaften Ausführungsform eines erfindungsgemäßen Verfahrens zum Betreiben eines MRT-Systems;
- FIG 3: eine schematische Darstellung einer eindimensionalen MR-Projektionsmessung zur Verwendung in einer beispielhaften Ausführungsform eines erfindungsgemäßen Verfahrens zum Lokalisieren eines Objekts;
- FIG 4: eine schematische Darstellung einer eindimensionalen MR-Projektionsmessung zur Verwendung in einer weiteren beispielhaften Ausführungsform eines erfindungsgemäßen Verfahrens zum Lokalisieren eines Objekts; und
- FIG 5: eine schematische Darstellung einer MR-Abbildungsmesssequenz zur Verwendung in einer weiteren beispielhaften Ausführungsform eines erfindungsgemäßen Verfahrens zum Betreiben eines MRT-Systems.

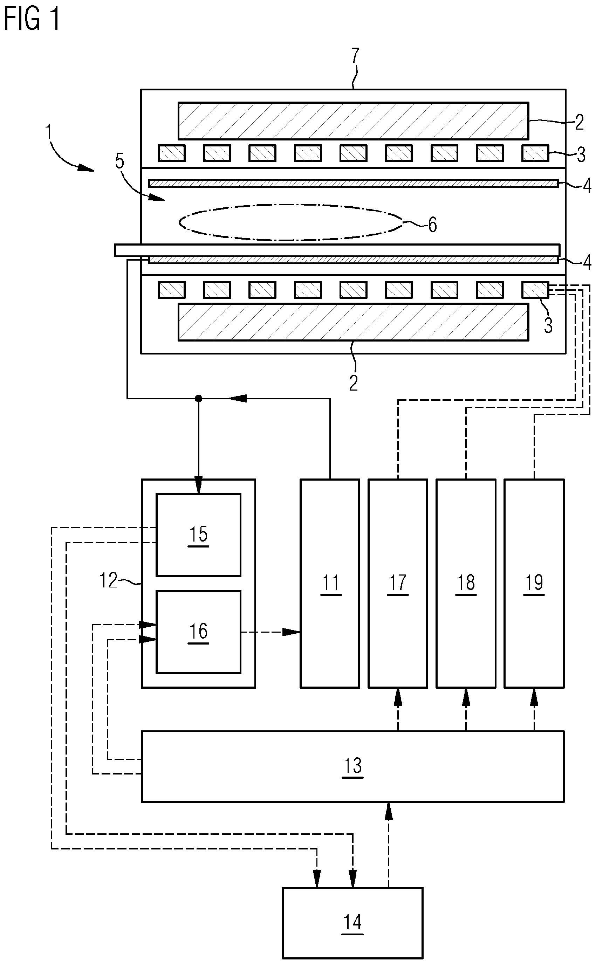

Fig. 1 zeigt schematisch eine beispielhafte Ausführungsform eines MRT-Systems 1 gemäß der Erfindung. Das MRT-System 1 umfasst einen MRT-Scanner mit einem Scannergehäuse 7, das eine Untersuchungsröhre 5 definiert, und eine Hauptmagnetanordnung 2, die dazu eingerichtet ist, dass ein Hauptmagnetfeld, auch als polarisierendes Magnetfeld oder B0 bezeichnet, innerhalb der Untersuchungsröhre 5 erzeugt. Das MRT-System 1 umfasst ein HF-System 4, 11, 12, das dazu eingerichtet ist, HF-Impulse in Richtung eines in der Untersuchungsröhre 5 angeordneten Objekts 6, insbesondere einen Körperteil eines Patienten, einzustrahlen und die von dem Objekt 6 ausgesendeten MR-Signale zu empfangen. Die Hauptmagnetanordnung 2 kann zum Beispiel ein homogenes Hauptmagnetfeld erzeugen und mindestens eine HF-Spule 4 des HF-Systems 4, 11, 12 kann ein HF-Feld B1 aussenden. Das MRT-System 1 außerdem einen Sequenz-Controller 13.

Gemäß bekannter MRT-Techniken wird das Objekt 6 dem Hauptmagnetfeld ausgesetzt, wodurch die Kernspins in dem Objekt um die Richtung des Hauptmagnetfeldes in Präzession mit ihrer charakteristischen Larmor-Frequenz versetzt werden. In der Richtung Z des Hauptmagnetfeldes wird ein magnetisches Nettomoment Mz erzeugt, und die zufällig orientierten magnetischen Momente der Kernspins heben sich in der x-y-Ebene gegenseitig auf.

Wenn das Objekt 6 dann dem HF-Feld ausgesetzt wird, das beispielsweise in der X-Y-Ebene und nahe der Larmor-Frequenz liegt, dreht sich das magnetische Nettomoment aus der Z-Richtung heraus und erzeugt ein magnetisches Nettomoment, dessen Projektion sich in der X-Y-Ebene mit der Larmor-Frequenz dreht. In Reaktion darauf werden von den angeregten Spins MR-Signale ausgesandt, wenn sie in ihren Zustand vor der Anregung zurückkehren. Die emittierten MR-Signale werden beispielsweise von der mindestens einen HF-Spule 4 und/oder einer oder mehreren speziellen Empfangsspulen erfasst, in einem Empfangskanal 15 eines HF-Controllers 12 des HF-Systems 4, 11, 12 digitalisiert und von mindestens einem Prozessor verarbeitet, um ein MR-Bild zu rekonstruieren, beispielsweise mittels einer bekannten Rekonstruktionstechnik.

Insbesondere können die Gradientenspulen 3 des MRT-Systems 1 Magnetfeldgradienten Gx, Gy und Gz für die Ortskodierung der MR-Signale erzeugen. Dementsprechend werden MR-Signale nur von solchen Kernen des Objekts 6 ausgesendet, die der jeweiligen Larmor-Frequenz entsprechen. Gz wird zum Beispiel zusammen mit einem HF-Impuls verwendet, um eine Schicht senkrecht zur Z-Richtung auszuwählen und kann daher auch als Schichtauswahlgradient bezeichnet werden. In einem alternativen Beispiel können Gx, Gy und Gz in einer beliebigen vordefinierten Kombination mit einem HF-Impuls verwendet werden, um eine Schicht senkrecht zur Vektorsumme der Gradientenkombination auszuwählen. Die Gradientenspulen 3 können von den jeweiligen Verstärkern 17, 18, 19 mit Strom versorgt werden, um die jeweiligen Gradientenfelder in X-Richtung, Y-Richtung beziehungsweise in Z-Richtung zu erzeugen. Jeder Verstärker 17, 18, 19 kann einen entsprechenden Digital-Analog-Wandler enthalten, der von dem Sequenz-Controller 13 gesteuert wird, um entsprechende Gradientenimpulse zu vordefinierten Zeitpunkten zu erzeugen.

Die Sequenzsteuerung 13 kann die Erzeugung von HF-Impulsen durch einen Emitterkanal 16 des HF-Controllers 12 und einen HF-Leistungsverstärker 11 des HF-Systems 4, 11, 12 steuern.

Es sei darauf hingewiesen, dass die Komponenten des MRT-Systems 1 auch anders angeordnet sein können als in FIG 1 dargestellt. Zum Beispiel können die Gradientenspulen 3 innerhalb der Untersuchungsröhre 5 angeordnet sein, ähnlich wie bei der mindestens einen HF-Spule 4 gezeigt. Es wird ferner darauf hingewiesen, dass jede Komponente des MRT-Systems 1 weitere Elemente enthalten kann, die für ihren Betrieb erforderlich sind, und/oder zusätzliche Elemente, die andere als die in der vorliegenden Offenlegung beschriebenen Funktionen bereitstellen.

Das MRT-System 1 umfasst ein Datenverarbeitungssystem 14, das dazu eingerichtet ist, ein erfindungsgemäßes Verfahren zum Lokalisieren des Objekts 6 in der Untersuchungsröhre 5 durchzuführen. Als Ergebnis dieses Verfahrens bestimmt das Datenverarbeitungssystem 14 wenigstens einen Abstand des Objekts 6 zu einer Innenwand 20 der Untersuchungsröhre 5, insbesondere wenigstens einen Abstand in der X-Y-Ebene.

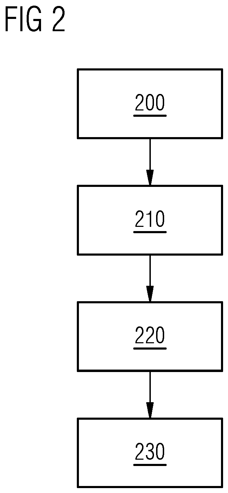

Das MRT-System 1 kann auch ein erfindungsgemäßes Verfahren zum Betreiben eines MRT-Systems durchführen. FIG 2 zeigt schematisch ein Ablaufdiagramm eines solchen Verfahrens mit Schritten 200 bis 230, wobei die Schritte 200 und 210 ein erfindungsgemäßes Verfahren zum Lokalisieren des Objekts 6 in der Untersuchungsröhre 5 darstellen.

In Schritt 200 erhält das Datenverarbeitungssystem 14 Projektionsmessdaten 23 einer MR- Projektionsmessung in wenigstens einer Richtung senkrecht zu einer Längsrichtung der Untersuchungsröhre 5 beziehungsweise die Projektionsmessdaten 23 werden erzeugt, indem die MR-Projektionsmessung durch das MRT-System 1 durchgeführt wird. In Schritt 210 bestimmt das Datenverarbeitungssystem 14 abhängig von den Projektionsmessdaten 23 wenigstens einen Abstand des Objekts 6 zu einer Innenwand 20 der Untersuchungsröhre 5.

In Schritt 220 bestimmt das Datenverarbeitungssystem 14 einen zulässigen Bereich für eine Sendeleistung wenigstens einer Sendespule, beispielsweise der HF-Spule 4, des MRT-Systems 1, die außerhalb der Untersuchungsröhre 5 verbaut ist, abhängig von dem wenigstens einen Abstand. Dazu bestimmt das Datenverarbeitungssystem 14 insbesondere eine maximale Sendeleistung Pₘₐₓ für die wenigstens eine Sendespule, sodass die mittlere quadratische HF-Feldstärke |B1|² gemittelt über einen vorgegebenen Zeitraum, beispielsweise 10 s oder 6 min, einen vorgegebenen Maximalwert nicht überschreitet, wenn die wenigstens eine Sendespule mit der maximalen Sendeleistung Pₘₐₓ betrieben wird. Beispielsweise kann auch für mehrere vorgegebene Zeiträume ein entsprechender Maximalwert vorgegeben sein. Die maximale Sendeleistung Pₘₐₓ kann dann insbesondere derart bestimmt werden, dass die mittlere quadratische HF-Feldstärke |B1|² den jeweiligen Maximalwert für keinen der Zeiträume überschreitet.

In Schritt 230 wird mittels des MRT-Systems 1 wenigstens ein Teil einer MR-Abbildungsmesssequenz 25 zur Abbildung des Objekts 6 durchgeführt, wobei die Sendeleistung wenigstens einer Sendespule auf den zulässigen Bereich beschränkt wird.

Die Schritte 200 bis 230 können auch mehrfach durchgeführt werden, wobei jeweils zwischen aufeinanderfolgenden Teilen der MR-Abbildungsmesssequenz 25 die MR-Projektionsmessung durchgeführt wird, um die Lage des Objekts 6 so kontinuierlich zu überwachen und den zulässigen Bereich entsprechend kontinuierlich beziehungsweise wiederholt anzupassen.

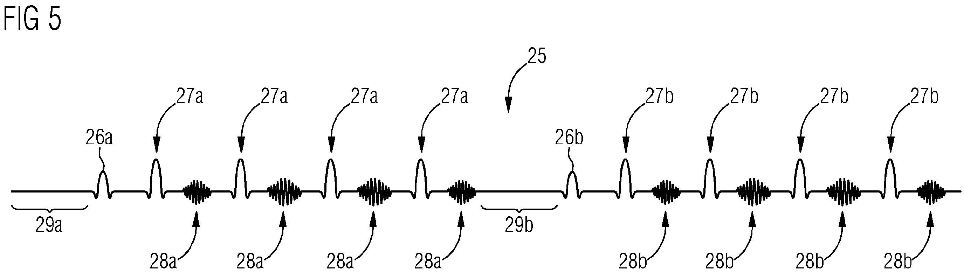

Zu diesem Aspekt zeigt FIG 5 eine schematische Darstellung einer MR-Abbildungsmesssequenz 25. Als Beispiel ist eine TSE-Sequenz gezeigt. Auf einen 90°-Puls 26a folgt eine Reihe von 180°-Pulsen 27a und nach jedem 180°-Puls 27a wird ein Spin-Echo-Signal 28a gemessen. Danach folgt ein weiterer 90°-Puls 26b gefolgt von einer weiteren Reihe von 180°-Pulsen 27b, wobei und nach jedem 180°-Puls 27b wiederum ein Spin-Echo-Signal 28b gemessen wird. MR-Projektionsmessungen können dann beispielsweise in einer Totzeitphase 29a vor dem 90°-Puls 26a und/oder in einer Totzeitphase 29b zwischen dem letzten Spin-Echo 28a und dem weiteren 90°-Puls 26b durchgeführt werden.

In manchen Ausführungsformen kann für die MR-Projektionsmessung eine PETRA-Sequenz genutzt werden. Diese bietet den Vorteil, dass mit sehr kleinen Flipwinkeln gearbeitet werden kann und somit die eigentliche Messung zur Abbildung des Objekts 6 nicht stört. Zudem ist sie mit ihren ultrakurzen Echozeiten besonders robust gegenüber ungewünschten Effekten in der Nähe der Innenwand 20, wie Gradientennichtlinearitäten, B0-Störungen und so weiter.

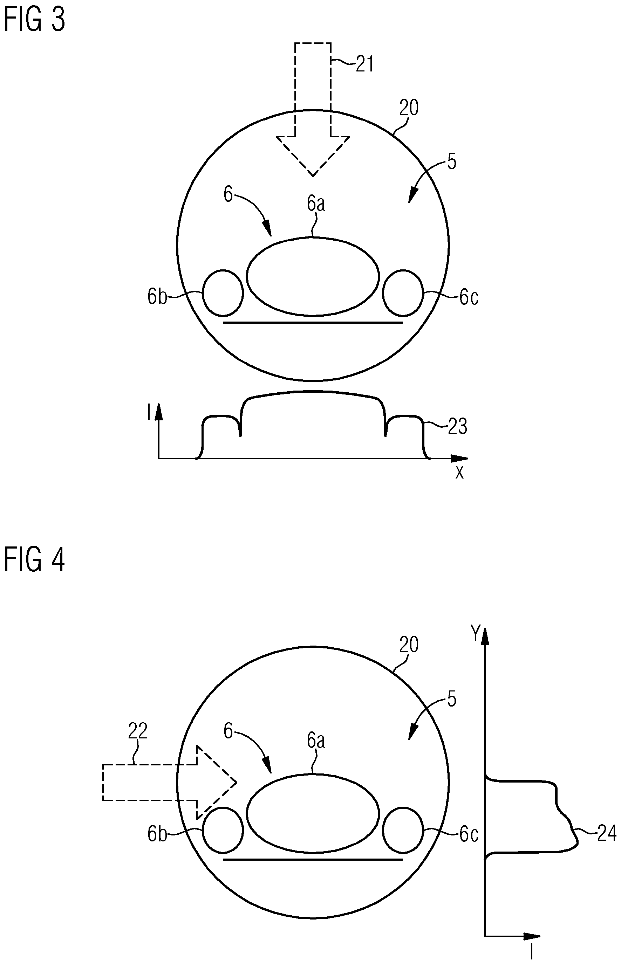

Es können sowohl zweidimensionale MR-Projektionsmessungen als auch eindimensionale MR-Projektionsmessungen genutzt werden. Insbesondere kann auch eine Kombination mehrerer eindimensionaler MR-Projektionsmessungen mit jeweils unterschiedlichen Richtungen in der X-Y-Ebene genutzt werden. Bei eindimensionalen MR-Projektionsmessungen wird nur eine Linie durch das Objekt 6 aufgenommen, wie schematisch in FIG 3 und FIG 4 für zwei unterschiedliche Projektionsrichtungen 21, 22 dargestellt.

Dementsprechend ist in FIG 3 der Fall skizziert, dass die eindimensionale MR-Projektionsmessung entlang der X-Richtung durchgeführt wird. Die resultierende Signalintensität im Bildraum I ist als Kurve 23 gezeigt. Es ist ersichtlich, dass die Kurve 23 im Bereich des Rumpfs 6a des Patienten am höchsten ist, im Bereich der Arme 6b, 6c etwas niedriger und dann in Richtung der Innenwand 20 jeweils auf Null abfällt. Die Position der Innenwand 20 ist im Koordinatensystem der Ortskodierung bekannt. Dementsprechend kann der jeweilige Abstand des Objekts 6 von der Innenwand 20 direkt aus der Position, an der die Kurve 23 auf Null geht, abgeleitet werden.

In FIG 4 ist der Fall skizziert, dass die eindimensionale MR-Projektionsmessung entlang der X-Richtung durchgeführt wird. Die resultierende Signalintensität im Bildraum I ist als Kurve 24 gezeigt. Es ist ersichtlich, dass die Kurve 24 nahe der Patientenliege 4 am höchsten ist und dann in Richtung der Innenwand 20 jeweils auf Null abfällt. Dementsprechend kann der jeweilige Abstand des Objekts 6 von der Innenwand 20 direkt aus der Position, an der die Kurve 24 auf Null geht, abgeleitet werden.

Eindimensionale MR-Projektionsmessungen haben den Vorteil, dass sie in sehr kurzer Zeit durchgeführt werden können, da nur eine Linie beziehungsweise Speiche durch den k-Raum abgetastet werden muss. Bei einer PETRA-Sequenz werden für eine komplette Speiche beispielsweise zumindest drei Repetitionen gemessen, nämlich zwei Repetitionen in entgegengesetzten radialen Richtungen vom k-Raum Zentrum aus, sowie mindestens eine für das k-raum Zentrum, wobei letztere gegebenenfalls aus vorangegangenen Messungen weiterverwendet werden kann. Alternativ kann bei der PETRA Sequenz für die Messung einer Speiche auch nur eine Radiale Messung durchgeführt werden und, wie aus dem Partial Fourier Transform Verfahren bekannt, die andere Hälfte der Speiche mit Zero-Filling abgedeckt werden. Da eine Repetition beispielsweise nur 2-3 ms dauert, kann die eindimensionale MR-Projektionsmessung in deutlich unter 10ms gemessen werden. Damit kann sie besonders vorteilhaft in Totzeitphasen 29a, 29b der eigentlich laufenden MR-Abbildungsmesssequenz 25 werden, bei einer TSE Acquisition zum Beispiel alle paar Sekunden am Ende eines TR-Zeitraums.

In manchen Ausführungsformen kann die eindimensionale Projektionsrichtung bei jedem Durchgang geändert werden, sodass aus verschiedenen Richtungen projiziert wird.

In manchen Ausführungsformen ist vorgesehen, eine vollständige zweidimensionale oder auch dreidimensionale Referenzmessung zu Beginn der Untersuchung durchzuführen. Die später erfassten Projektionsmessdaten können dann mit den Ergebnissen aus der Referenzmessung abgeglichen werden, wobei insbesondere die Referenzmessung in die entsprechenden Richtungen der Projektionsmessdaten umgerechnet wird. So können Änderungen in der Lage des Objekts 6 schnell erkannt werden.

In verschiedenen Ausführungsformen der Erfindung wird ein Verfahren vorgeschlagen, mit dem anhand von eindimensionalen oder zweidimensionalen MR-Projektionsmessungen Informationen über die Lagerung eines Objekts während einer laufenden MR-Abbildungsmesssequenz 25 ermittelt werden können. Vorteile des Verfahrens beinhalten, dass die Überwachung der Lagerung und vor allem der minimale Abstand des Objekts 6 von der Innenwand 20 auch während einer laufenden Untersuchung und vor allem ohne weitere externe Sensoren möglich ist.

Unabhängig vom grammatikalischen Geschlecht eines bestimmten Begriffes sind Personen mit männlicher, weiblicher oder anderer Geschlechteridentität mit umfasst.

## Patentansprüche

1. Verfahren zur Lokalisierung eines abzubildenden Objekts (6) in einer Untersuchungsröhre (5) eines MRT-Systems (1) wobei
- Projektionsmessdaten (23) einer MR-Projektionsmessung in wenigstens einer Richtung senkrecht zu einer Längsrichtung der Untersuchungsröhre (5) erhalten werden; und
- abhängig von den Projektionsmessdaten (23) wenigstens ein Abstand des Objekts (6) zu einer Innenwand (20) der Untersuchungsröhre (5) bestimmt wird.

2. Verfahren nach Anspruch 1, wobei die MR-Projektionsmessung
- eine zweidimensionale MR-Projektionsmessung ist; und/oder
- eine Encoding-Time-Reduction-With-Radial-Acquisition-, PETRA-, Sequenz oder einen Teil einer PETRA-Sequenz beinhaltet; und/oder
- eine Ultrashort Echo-Time-, UTE-, Sequenz oder einen Teil einer UTE-Sequenz beinhaltet; und/oder
- eine Zero Echo-Time-, ZTE-, Sequenz oder einen Teil einer ZTE-Sequenz beinhaltet.

3. Verfahren nach Anspruch 1, wobei die MR-Projektionsmessung eine eindimensionale erste MR-Projektionsmessung in einer ersten Richtung senkrecht zu der Längsrichtung der Untersuchungsröhre (5) ist, die Projektionsmessdaten (23) erste Projektionsmessdaten (23) sind, und wenigstens ein erster Abstand des wenigstens einen Abstands abhängig von den ersten Projektionsmessdaten (23) bestimmt wird.

4. Verfahren nach Anspruch 3, wobei
- zweite Projektionsmessdaten (24) einer eindimensionalen zweiten MR-Projektionsmessung in einer zweiten Richtung senkrecht zu der Längsrichtung der Untersuchungsröhre (5) erhalten werden; und
- abhängig von den zweiten Projektionsmessdaten (24) wenigstens ein zweiter Abstand des wenigstens einen Abstands bestimmt wird.

5. Verfahren nach einem der vorhergehenden Ansprüche, wobei Referenzmessdaten einer MR-Referenzmessung erhalten werden und eine Positionsveränderung des Objekts (6) in der Untersuchungsröhre (5) abhängig von einem Abgleich der Projektionsmessdaten (23) mit den Referenzmessdaten detektiert wird.

6. Verfahren nach einem der vorhergehenden Ansprüche, wobei die MR-Projektionsmessung aus wenigstens einer MR-Projektionsmesssequenz besteht, wobei eine maximale Echozeit der MR-Projektionsmesssequenz kleiner oder gleich 2 ms oder kleiner oder gleich 1 ms ist.

7. Verfahren nach einem der vorhergehenden Ansprüche, wobei abhängig von den Projektionsmessdaten (23) wenigstens eine Position in einer Ebene senkrecht zu der Längsrichtung der Untersuchungsröhre (5) bestimmt wird, an der eine MR-Signalintensität gemäß den Projektionsmessdaten (23) kleiner oder gleich einem vorgegebenen Grenzwert ist und der wenigstens eine Abstand basierend auf der wenigstens einen Position bestimmt wird.

8. Verfahren zum Betreiben eines MRT-Systems (1), wobei
- ein Verfahren zur Lokalisierung eines abzubildenden Objekts (6) in einer Untersuchungsröhre (5) des MRT-Systems (1) nach einem der vorhergehenden Ansprüche durchgeführt wird;
- ein zulässiger Bereich für eine Sendeleistung wenigstens einer Sendespule (4) des MRT-Systems (1), die außerhalb der Untersuchungsröhre (5) verbaut ist, abhängig von dem wenigstens einen Abstand bestimmt wird; und
- wenigstens ein Teil einer MR-Abbildungsmesssequenz (25) zur Abbildung des abzubildenden Objekts (6) durchgeführt wird, wobei die Sendeleistung wenigstens einer Sendespule (4) auf den zulässigen Bereich beschränkt wird.

9. Verfahren nach Anspruch 8, wobei
- die MR-Projektionsmessung wenigstens zum Teil während einer Totzeitphase (29b) zwischen einem ersten Teil der MR-Abbildungsmesssequenz (25) und einem zweiten Teil der MR-Abbildungsmesssequenz (25) durchgeführt wird; und
- die Sendeleistung der wenigstens einen Sendespule (4) während des zweiten Teils der MR-Abbildungsmesssequenz (25) auf den zulässigen Bereich beschränkt wird.

10. Verfahren nach einem der Ansprüche 8 oder 9, wobei der wenigstens eine Abstand des Objekts (6) zu der Innenwand (20) zwei oder mehr Abstände des Objekts (6) zu der Innenwand (20) an verschiedenen Positionen in einer Ebene senkrecht zu der Längsrichtung der Untersuchungsröhre (5) beinhaltet und der zulässige Bereich für die Sendeleistung abhängig von einem minimalen Abstand der zwei oder mehr Abstände bestimmt wird.

11. Verfahren nach einem der Ansprüche 8 bis 10, wobei der zulässige Bereich abhängig von einem vorgegebenen Maximalwert für den mittleren Betrag der Amplitude eines B1-Feldes oder für die mittlere quadratische Amplitude des B1-Feldes während eines vorgegebenen Zeitraums bestimmt wird.

12. Datenverarbeitungssystem (14), das dazu angepasst ist, ein Verfahren nach einem der Ansprüche 1 bis 7 durchzuführen.

13. MRT-System (1) zur Durchführung einer MR-Abbildungsmesssequenz (25) zur Abbildung eines abzubildenden Objekts (6), das MRT-System (1) aufweisend einen MRT-Scanner (7) mit einer Untersuchungsröhre (5) sowie ein Datenverarbeitungssystem (14) nach Anspruch 12.

14. MRT-System (1) nach Anspruch 13, aufweisend ein Steuerungssystem (11, 12, 13, 15, 16, 17, 18, 19) zur Ansteuerung des MRT-Scanners (7), wobei
- der MRT-Scanner (7) wenigstens eine Sendespule (4) aufweist, die außerhalb der Untersuchungsröhre (5) verbaut ist;
- das Datenverarbeitungssystem (14) dazu angepasst ist, abhängig von dem wenigstens einen Abstand einen zulässigen Bereich für eine Sendeleistung der wenigstens einen Sendespule (4) zu bestimmen; und
- das Steuerungssystem (11, 12, 13, 15, 16, 17, 18, 19) dazu eingerichtet ist, den MRT-Scanner (7) zur Durchführung der MR-Abbildungsmesssequenz (25) anzusteuern, sodass die Sendeleistung der wenigstens einen Sendespule (4) auf den zulässigen Bereich beschränkt wird.

15. Computerprogrammprodukt aufweisend
- Befehle, die bei Ausführung durch ein Datenverarbeitungssystem (14) das Datenverarbeitungssystem (14) dazu veranlassen, ein Verfahren nach einem der Ansprüche 1 bis 7 durchzuführen; und/oder
- weitere Befehle, die bei Ausführung durch ein MRT-System (1) nach einem der Ansprüche 13 oder 14 das MRT-System (1) dazu veranlassen, ein Verfahren nach einem der Ansprüche 8 bis 11 durchzuführen.
